# EUROPÄISCHE PATENTSCHRIFT

(11) **EP 1 859 288 B1**
(45) Veröffentlichungstag und Bekanntmachung des Hinweises auf die Patenterteilung: **16.03.2011**
(21) Anmeldenummer: 06707830.3
(22) Anmeldetag: 25.01.2006
(51) Int. Cl.: G01R 31/02

(54) **VERFAHREN UND SCHALTUNGSANORDNUNG ZUR DETEKTION EINES LEITUNGSBRUCHES**
METHOD AND CIRCUIT FOR DETECTING A LINE BREAK
PROCEDE ET ENSEMBLE CIRCUIT POUR LA DETECTION D'UNE RUPTURE DE LIGNE

(30) Priorität: 17.03.2005 DE 102005012405
(43) Veröffentlichungstag der Anmeldung: 28.11.2007
(73) Patentinhaber: Continental Automotive GmbH, 30165 Hannover (DE)
(72) Erfinder: WOLFARTH, Gunther, 93055 Regensburg-Harting (DE); FÖRSTER, Ralf, 93053 Regensburg (DE)
(86) Internationale Anmeldenummer: PCT/EP2006/050426
(87) Internationale Veröffentlichungsnummer: WO 2006/097377

(56) Entgegenhaltungen:
- DE-A1- 4 403 375
- US-A- 5 111 123
- US-A- 5 592 097

## Beschreibung

Die Erfindung betrifft ein Verfahren und eine Schaltungsanordnung zur kontinuierlichen Detektion eines Leitungsbruches bei einer Vollbrücke, welche vier zwischen einem Versorgungspotential und einem Massepotential betriebenen Schaltvorrichtungen enthält und eine Last steuert, wobei zu jeder Schaltvorrichtung jeweils eine Diode parallel geschaltet ist.

Das technische Gebiet der Erfindung betrifft die Detektion eines Leitungsbruches bei einer Vollbrücke. Bekanntermaßen werden Vollbrücken und H-Brücken zur Ansteuerung von Gleichstrommotoren im Kraftfahrzeug, zum Beispiel Drosselklappe, Abgasrückführung oder dergleichen verwendet, um den Gleichstrommotor in einer Vorwärtsrichtung und in einer Rückwärtsrichtung betreiben zu können. Dabei ist es aus Diagnosezwecken wichtig, potenzielle Leitungsbrüche bei der Vollbrücke bzw. H-Brücke auch während des Betriebes des Gleichstrommotors zu detektieren.

Bisher sind zwei Methoden bekannt geworden, einen Leitungsbruch an einer Vollbrücke zu erkennen. Die erste Methode basiert auf einer Strommessung. Hierbei wird der Strom durch die Vollbrücke gemessen und mit einem Referenzstrom verglichen. Unterschreitet der gemessene Strom den Referenzstrom, wird bekanntermaßen davon ausgegangen, dass ein Leitungsbruch vorliegt. Allerdings ist der Stromanstieg im Aktuator bzw. Motor von dessen elektrischen Eigenschaften abhängig. Somit kann es bei zu kurz eingestellten Einschaltzeiten zu einer fehlerhaften Leitungsbrucherkennung kommen. Dies kann durch eine geeignete Wahl der Filterzeit vermieden werden. Damit ist aber ein hoher Aufwand gegeben, die Filterzeit für den jeweiligen Aktuator anzupassen. Das heißt für jeden verwendeten Aktuator muss diese Filterzeit erst bestimmt und dann für den Aktuator eingestellt werden. Für die Anpassung an den jeweiligen Aktuator müssen Zeit und Anpassungstest aufgebracht werden. Dabei werden zusätzliche Kosten für die Detektion von Leitungsbrüchen verursacht.

Die zweite Methode basiert auf einer Spannungsmessung. Hierzu werden geeignete Vorrichtungen für eine Diagnose an den Ausgängen der Vollbrücke vorgesehen. Nachteiligerweise muss bei dieser zweiten Methode sichergestellt sein, dass sich die Vollbrücke bei der Diagnose im ausgeschalteten Zustand befindet. Demnach ist bei dieser zweiten Methode keine kontinuierliche Leitungsbrucherkennung, also keine Diagnose während des Betriebs des Aktuators möglich. Des Weiteren muss die Spannungsmessung für die Leitungsbrucherkennung bei der zweiten Methode initiiert, also veranlasst werden. Diese erfordert gegenüber der ersten Methode zusätzlich einen weiteren Zeitaufwand.

Die Druckschrift US 5,111,123 A offenbart ein Detektionsgerät zur Detektion eines Leitungsbruches bei einer Vollbrücke. Das Detektionsgerät weist eine Steuerung auf, welche die Vollbrücke umschaltet oder ausschaltet, wobei die Steuerung eine vorbestimmbare Schaltvorrichtung zuerst umschalten kann.

Weiter ist eine Schaltung zur Detektion eines Leitungsbruches bei einer eine induktive Last ansteuernden Vollbrücke aus der US 5,592,097 A bekannt.

Die der vorliegenden Erfindung zugrunde liegende Aufgabe besteht daher darin, eine kontinuierliche Leitungsbrucherkennung an einer Vollbrücke durchzuführen, wobei die Leitungsbrucherkennung unabhängig von dem durch die induktive Last fließenden Strom sein soll.

Erfindungsgemäß wird die gestellte Aufgabe durch ein Verfahren mit den Merkmalen des Patentanspruchs 1 sowie durch eine Schaltungsanordnung mit den Merkmalen des Patentanspruchs 2 gelöst.

Vorteilhafterweise wird erfindungsgemäß eine kontinuierliche Leitungsbruch-Detektion im geschalteten Betrieb der induktiven Last bzw. des induktiven Aktuators ermöglicht. Das erfindungsgemäße Verfahren bzw. die erfindungsgemäße Schaltungsanordnung muss nicht auf die jeweilige anzusteuernde Last bzw. auf den jeweiligen Aktuator angepasst werden. Außerdem muss die Potentialmessung für die Detektion nicht eigens initiiert werden. Dadurch ermöglicht die

Erfindung eine einfache und somit auch kostengünstige Detektion von Leitungsbrüchen bei Vollbrücken.

Vorteilhafte Ausgestaltungen und Weiterbildungen der Erfindung ergeben sich aus den Unteransprüchen sowie der Beschreibung unter Bezugnahme auf die Zeichnungen.

Gemäß einer bevorzugten Weiterbildung der Erfindung wird jeweils eine Diode parallel zu einer Laststrecke jeder Schaltvorrichtung angeordnet. Durch die jeweils angeordnete Diode wird sichergestellt, dass auch Potenzialunterschiede beim Schalten der Schaltungsanordnung, also beim Betrieb der Last messbar sind.

Gemäß einer bevorzugten Ausgestaltung der Erfindung generiert die Steuerschaltung jeweils ein Steuersignal für die Schaltvorrichtungen, mit denen die Schaltvorrichtungen jeweils umschaltbar sind, wobei die Steuerschaltung genau eines der vier Steuersignale vor den anderen Steuersignalen zum Schalten an eine vorbestimmbare Schaltvorrichtung überträgt. Vorteilhafterweise generiert die Steuerschaltung in Abhängigkeit der Richtungsvorgabe und des Ansteuertaktes eine Ansteuerung, die Querströme beim Schalten zwischen den Betriebsrichtungen und zwischen Einschalten und Freilauf verhindert. Der Freilauf kann aktiv über einen im Freilaufpfad aktivierten Schalter oder passiv über eine parallel geschaltete Diode erfolgen.

Gemäß einer weiteren bevorzugten Ausgestaltung weist die Vergleichseinrichtung auf:
a) einen ersten Komparator, welcher ein erstes Potential, das an einer Verbindung zwischen der ersten Schaltvorrichtung und der Last anliegt, mit dem Versorgungspotential vergleicht und ausgangsseitig einen positiven logischen Signalpegel bereitstellt, falls die beiden verglichenen Potentiale im Freilauf ungleich sind;
b) einen zweiten Komparator, welcher ein zweites Potential einer Verbindung zwischen der zweiten Schaltvorrichtung und der Last mit dem Versorgungspotential vergleicht und ausgangsseitig einen positiven logischen Signalpegel bereitstellt, falls die beiden verglichenen Potentiale im Freilauf ungleich sind;
c) einen dritten Komparator, welcher ein drittes Potential einer Verbindung zwischen der dritten Schaltvorrichtung und der Last mit dem Massepotential vergleicht und ausgangsseitig einen positiven logischen Signalpegel bereitstellt, falls die beiden verglichenen Potentiale im Freilauf ungleich sind; und
d) einen vierten Komparator, welcher ein viertes Potential einer Verbindung zwischen der vierten Schaltvorrichtung und der Last mit dem Massepotential vergleicht und ausgangsseitig einen positiven logischen Signalpegel bereitstellt, falls die beiden verglichenen Potentiale im Freilauf ungleich sind.

Gemäß einer weiteren bevorzugten Ausgestaltung wertet die Auswerteeinrichtung die von den Komparatoren ausgangsseitig bereitgestellten Signalpegel aus und stellt dabei einen Leitungsbruch fest, falls kein Komparator im Freilauf einen positiven Signalpegel liefert. Vorteilhafterweise bewertet die Auswerteschaltung hierbei, ob die Ansteuerung ausreichend war, um einen Freilauf zu erzeugen.

Gemäß einer weitern bevorzugten Ausgestaltung ist zumindest eine Schaltvorrichtung als MOSFET, insbesondere als Leistungs-MOSFET ausgebildet. Dadurch, dass der MOSFET technologiebedingt bereits eine Freilaufdiode aufweist, muss vorteilhafterweise bei der Verwendung eines MOSFETs keine eigens zu der Schaltvorrichtung parallel geschaltete Diode vorgesehen werden.

Gemäß einer weiteren bevorzugten Ausgestaltung sind die vier Schaltvorrichtungen jeweils als ein Bipolartransistor und die jeweilige Diode als eine externe zu dem Bipolartransistor parallel geschaltete Diode ausgebildet.

Gemäß einer weiteren bevorzugten Ausgestaltung sind die vier Schaltvorrichtungen jeweils als ein Darlington-Transistor und die jeweilige Diode als eine externe zu dem Darlington-Transistor parallel geschaltete Diode ausgebildet.

Gemäß einer weiteren bevorzugten Ausgestaltung ist zumindest eine Schaltvorrichtung als IGBT (Insulated Gate Bipolartransistor) und die jeweilige Diode als eine externe zu dem jeweiligen IGBT parallel geschaltete Diode ausgebildet.

Die Erfindung wird nachfolgend anhand der in den schematischen Figuren angegebenen Ausführungsbeispielen näher erläutert. Es zeigen:
- Fig. 1: ein schematisches Blockdiagramm eines bevorzugten Ausführungsbeispiels einer erfindungsgemäßen Schaltungsanordnung zur kontinuierlichen Detektion eines Leitungsbruches bei einer Vollbrücke bei Freilauf nach Versorgungspotential;
- Fig. 2: ein schematisches Blockdiagramm des bevorzugten Ausführungsbeispiels der erfindungsgemäßen Schaltungsanordnung zur kontinuierlichen Detektion eines Leitungsbruches bei einer Vollbrücke bei Freilauf nach Massepotential gemäß Fig. 1, und
- Fig. 3: ein schematisches Ablaufdiagramm eines bevorzugten Ausführungsbeispiels des erfindungsgemäßen Verfahrens zur kontinuierlichen Detektion eines Leitungsbruches bei einer Vollbrücke.

In allen Figuren sind gleiche bzw. funktionsgleiche Elemente und Signale - sofern nichts anderes angegeben ist - mit denselben Bezugszeichen versehen worden.

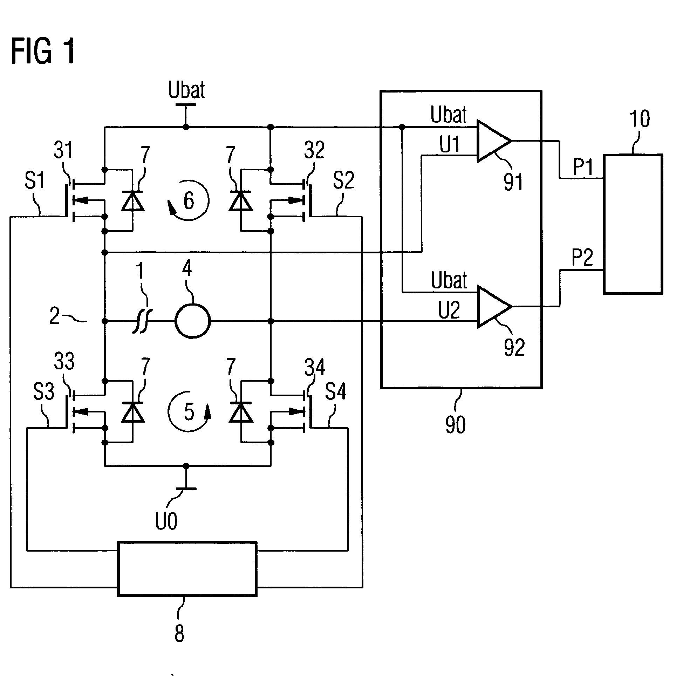

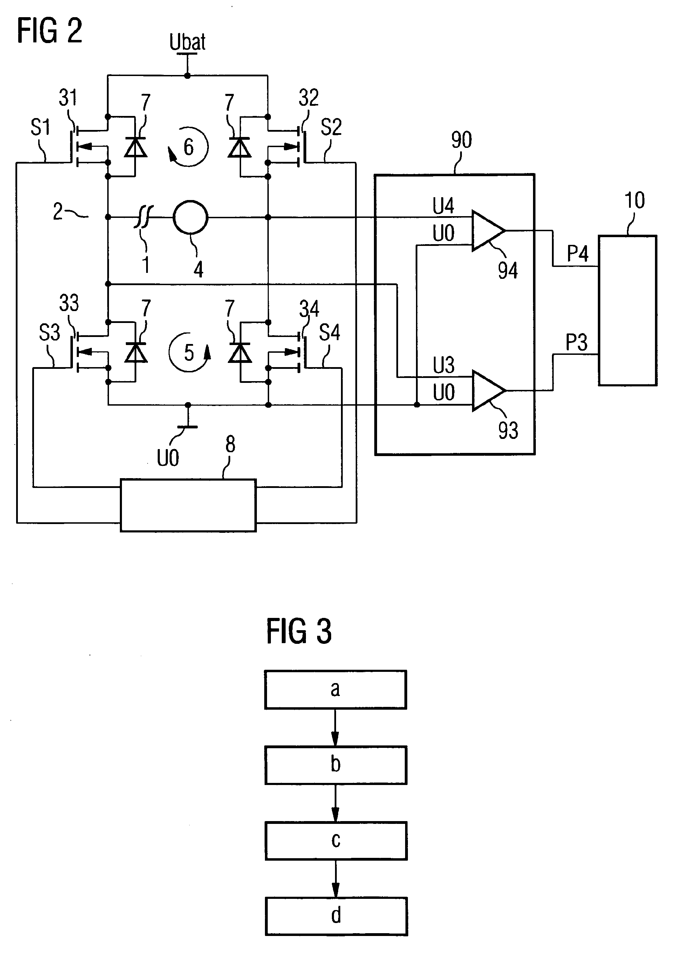

Aus Gründen der Übersichtlichkeit sind zur Darstellung der erfindungsgemäßen Schaltungsanordnung die Fig. 1 und 2 vorgesehen. In Fig. 1 sind die Komparatoren 91 und 92 einer Vergleichseinrichtung 90 dargestellt, welche Freilaufspannungen bei einem Freilauf der Last 4 nach dem Versorgungspotential 6 detektieren und die detektierten Signalpegel P1, P2 zu einer Auswerteeinrichtung 10 übertragen. Dagegen sind in Fig. 2 die Komparatoren 93 und 94 der Vergleichseinrichtung 90 dargestellt sind, welche Freilaufspannungen bei einem Freilauf der Last 4 nach Massepotential 5 detektieren und die detektierten Signalpegel P3, P4 zu der Auswerteeinrichtung 10 übertragen.

Fig. 1 zeigt also ein schematisches Blockdiagramm eines bevorzugten Ausführungsbeispiels einer Schaltungsanordnung zur kontinuierlichen Detektion eines Leitungsbruches 1 bei einer Vollbrücke 2 bei Freilauf nach Versorgungspotential 6.

Die Schaltungsanordnung weist eine Vollbrücke 2 auf. Die Vollbrücke 2 besteht aus vier, zwischen einem Versorgungspotential Ubat und einem Massepotential U0 betriebenen Schaltvorrichtungen 31-34. Zu jeder Schaltvorrichtung 31-34 ist jeweils eine Diode 7 parallel geschaltet. Die Vollbrücke 2 dient zur Ansteuerung einer induktiven Last 4.

Die erfindungsgemäße Schaltungsanordnung weist weiter eine Steuerschaltung 8 auf, welche jeweils ein Steuersignal S1-S4 zur Ansteuerung der Schaltvorrichtungen 31-34 erzeugt, mit denen die Schaltvorrichtungen 31-34 jeweils schaltbar sind. Beispielsweise steuert die Steuerschaltung 8 die erste Schaltvorrichtung 31 mittels des ersten Steuersignals S1. Außerdem überträgt die Steuerschaltung 8 genau eines der vier Steuersignal S1-S4 mit einer kurzen zeitlichen Verzögerung zum Umschalten an eine vorbestimmbare Schaltvorrichtung 31-34, sodass Querströme vermieden werden.

Die erfindungsgemäße Schaltungsanordnung weist weiter einen ersten Komparator 91 auf, welcher ein erstes Potential U1 der Verbindung der ersten Schaltvorrichtung 31 und der Last 4 mit dem Versorgungspotential Ubat vergleicht und ausgangsseitig einen positiven logischen Signalpegel P1 bereitstellt, falls das erste Potential U1 im Freilauf größer als das Versorgungspotential Ubat ist (U1>Ubat). Ist U1=Ubat, so stellt der erste Komparator 91 einen negativen logischen Signalpegel bereit. Dies gilt analog für den Komparator 92 für U2=Ubat.

Die erfindungsgemäße Schaltungsanordnung weist auch einen zweiten Komparator 92 auf, welcher ein zweites Potential U2 der zweiten Schaltvorrichtung 32 und der Last 4 mit dem Versorgungspotential Ubat vergleicht und ausgangsseitig einen positiven logischen Signalpegel P2 bereitstellt, falls das zweite Potential U2 größer als das Versorgungspotential Ubat ist (U2>Ubat).

Außerdem weist die erfindungsgemäße Schaltungsanordnung eine Auswerteeinrichtung 10 auf, welche die von den Komparatoren 91,92 ausgangsseitig bereitgestellten Signalpegel P1.P2 auswertet und dabei einen Leitungsbruch 1 feststellt, falls kein positiver Signalpuls P1 oder P2 innerhalb eines Ansteuerzyklus auftritt.

Fig. 2 zeigt ein schematisches Blockdiagramm des bevorzugten Ausführungsbeispiels der erfindungsgemäßen Schaltungsanordnung zur kontinuierlichen Detektion des Leitungsbruches 1 bei der Vollbrücke 2 bei Freilauf nach Massepotential 5.

Um bei einem Freilauf nach Massepotential 5 einen Leitungsbruch 1 feststellen zu können, weist die Vergleichseinrichtung 90 der erfindungsgemäße Schaltungsanordnung die Komparatoren 93 und 94 auf. Ausgangsseitig sind der dritte und vierte Komparator 93, 94 genauso wie der erste Komparator 91 und der zweite Komparator 92 mit der Auswerteeinrichtung 10 verbunden.

Der dritte Komparator 93 vergleicht ein drittes Potential U3 der Verbindung der dritten Schaltvorrichtung 33 und der Last 4 mit dem Massepotential U0 und stellt ausgangsseitig einen positiven logischen Signalpegel P3 bereit, falls das dritte Potential U3 kleiner als das Massepotential U0 ist (U3<UO). Ist U3=U0, so stellt der dritte Komparator 93 einen negativen logischen Signalpegel bereit. Dies gilt analog für den Komparator 94 für U4=U0.

Der vierte Komparator 94 vergleicht ein viertes Potential U4 der Verbindung der vierten Schaltvorrichtung 34 und der Last 4 mit dem Massepotential U0 und stellt ausgangsseitig einen positiven logischen Signalpegel P4 bereit, falls das vierte Potential U4 kleiner als das Massepotential U0 ist (U4<UO).

Fig. 3 zeigt ein schematisches Ablaufdiagramm eines bevorzugten Ausführungsbeispiels des erfindungsgemäßen Verfahrens zur kontinuierlichen Detektion eines Leitungsbruches 1 bei der Vollbrücke 2, welches mittels der Schaltungsanordnung gemäß Fig. 1 und 2 durchführbar ist.

Das erfindungsgemäße Verfahren zur Detektion eines Leitungsbruches 1 wird beim Betrieb der Last 4 mit einem Ansteuertakt durchgeführt.

### Verfahrensschritt a:

Ausschalten oder Umschalten der Vollbrücke 2, wobei eine vorbestimmbare Schaltvorrichtung 31-34 zuerst geschaltet wird.

### Verfahrensschritt b:

Abgreifen eines an einer Verbindung zwischen der zuerst geschalteten Schaltvorrichtung 31-34 und der Last 4 anliegenden Potentials U1-U4.

### Verfahrensschritt c:

Vergleichen des abgegriffenen Potentials U1-U4 mit dem Versorgungspotential Ubat, falls die zuerst geschaltete Schaltvorrichtung 31-34 mit dem Massepotential U0 verbunden ist, oder dem Massepotential U0, falls die zuerst geschaltete Schaltvorrichtung 31-34 mit dem Versorgungspotential (6) verbunden ist.

### Verfahrensschritt d:

Feststellen eines Leitungsbruches 1, wenn die beiden verglichenen Potentiale U1-U4, U0, Ubat im Freilauf nicht ungleich sind.

Obwohl die vorliegende Erfindung vorstehend anhand der bevorzugten Ausführungsbeispiele beschrieben wurde, ist sie darauf nicht beschränkt, sondern auf vielfältige Art und Weise modifizierbar. Beispielsweise ist es auch denkbar, andere als die oben genannten Transistoren als Schaltvorrichtungen zu verwenden. Des Weiteren ist es auch möglich, die eingesetzten Komparatoren durch andere Vorrichtungen wie zum Beispiel Mikroprozessoren zu ersetzen, die die jeweiligen Potentiale vergleichen und bei einem positiven Vergleich einen positiven Signalpegel bereitstellen. Weiter ist es auch möglich, die Logik der Signalpegel umzukehren. Durch eine Umkehrung der Leitfähigkeitstypen der Schaltvorrichtungen n gegen p und umgekehrt ergeben sich beliebig viele andere Schaltungsvarianten, ohne vom prinzipiellen Erfindungsgedanken abzuweichen.

Es sei darauf hingewiesen, dass der in den Fig. 1 und 2 dargestellte Leitungsbruch 1 gerade an dieser Stelle nur beispielhaft zu sehen ist. Erfindungsgemäß können jegliche Leitungsbrüche 1 an beliebigen Stellungen der Schaltung detektiert werden und über eine geeignete Auswertung zugeordnet werden.

Die in Fig. 1 und 2 dargestellten vier Schaltvorrichtungen 31-34 sind hier als Leistungs-MOSFET und die jeweilige Diode 7 als eine parasitäre Diode des Leistungs-MOSFETs ausgebildet.

Allerdings können die vier Schaltvorrichtungen 31-34 gemäß Fig. 1 und 2 auch durch beliebig andere Schaltvorrichtungen, beispielsweise als Bipolartransistoren, als Darlington-Transistoren oder als IGBTs ausgebildet sein.

## Patentansprüche

1. Verfahren zur kontinuierlichen Detektion eines Leitungsbruches (1) bei einer eine induktiven Last (4) ansteuernden Vollbrücke (2), welche vier zwischen einem Versorgungspotential (Ubat) und einem Massepotential (U0) betriebene Schaltvorrichtungen (31-34) enthält, mit den Schritten:
a) Ausschalten oder Umschalten der Vollbrücke (2), wobei eine vorbestimmbare Schaltvorrichtung (31-34) zuerst geschaltet wird;
b) Abgreifen eines an einer Verbindung zwischen der zuerst geschalteten Schaltvorrichtung (31-34) und der Last (4) anliegenden Potentials (U1-U4);
gekenzeichnet durch:
c) Vergleichen des abgegriffenen Potentials (U1-U4) mit dem Versorgungspotential (Ubat), falls die zuerst geschaltete Schaltvorrichtung (33,34) mit dem Massepotential (U0) verbunden ist, oder dem Massepotential (U0), falls die zuerst geschaltete Schaltvorrichtung (31,32) mit dem Versorgungspotential (6) verbunden ist; und
d) Feststellen eines Leitungsbruches (1), wenn die beiden verglichenen Potentiale (U1-U4, U0, Ubat) im Freilauf nicht ungleich sind.

2. Schaltungsanordnung zur kontinuierlichen Detektion eines Leitungsbruches (1) bei einer eine induktive Last (4) ansteuernden Vollbrücke (2), welche vier zwischen einem Versorgungspotential (Ubat) und einem Massepotential (U0) betriebene Schaltvorrichtungen (31-34) enthält, mit:
a) einer Steuerschaltung (8), welche so eingerichtet ist, dass sie die Vollbrücke (2) umschaltet oder ausschaltet, wobei die Steuerschaltung (8) eine vorbestimmbare Schaltvorrichtung (31-34) zuerst schaltet;
gekenzeichnet durch:
b) eine Vergleichseinrichtung (90), welche so eingerichtet ist, dass sie eines an einer Verbindung zwischen der zuerst umgeschalteten Schaltvorrichtung (31-34) und der Last (4) anliegendes Potential (U1-U4) mit dem Versorgungspotential (Ubat), falls die zuerst geschaltete Schaltvorrichtung (33,34) mit dem Massepotential (U0) verbunden ist, oder dem Massepotential (U0) vergleicht, falls die zuerst geschaltete Schaltvorrichtung (31,32) mit dem Versorgungspotential (Ubat) verbunden ist, und ausgangsseitig einen positiven Signalpegel (P1-P4) bereitstellt, wenn die beiden verglichenen Potentiale (U1-U4, U0, Ubat) im Freilauf ungleich sind; und
c) eine Auswerteeinrichtung (10), welche so eingerichtet ist, daß sie eingangsseitig den bereitgestellten Signalpegel (P1-P4) empfängt und feststellt, dass ein Leitungsbruch (1) vorliegt, wenn der empfangene Signalpegel (P1-P4) im Freilauf nicht positiv ist.

3. Schaltungsanordnung nach Anspruch 2,
**dadurch gekennzeichnet,**
**dass** jeweils eine Diode (7) parallel zu einer Laststrecke jeder Schaltvorrichtung (31-34) angeordnet ist.

4. Schaltungsanordnung nach Anspruch 2,
**dadurch gekennzeichnet,**
**dass** die Steuerschaltung (8) so eingerichtet ist, daß er jeweils ein Steuersignal (S1-S4) für die Schaltvorrichtungen (31-34) generiert, mit denen die Schaltvorrichtungen (31-34) jeweils umschaltbar sind, wobei die Steuerschaltung (8) genau eines der vier Steuersignale (S1 - S4) vor den anderen Steuersignalen (S1-S4) zum Umschalten an eine vorbestimmbare Schaltvorrichtung (31-34) überträgt

5. Schaltungsanordnung nach Anspruch 2,
**dadurch gekennzeichnet,**
**dass** die Vergleichseinrichtung (90) aufweist:
a) einen ersten Komparator (91), welcher so eingerichtet ist daβer ein erstes Potential (U1), das an einer Verbindung zwischen der ersten Schaltvorrichtung (31) und der Last (4) anliegt, mit dem Versorgungspotential (Ubat) vergleicht und ausgangsseitig einen positiven logischen Signalpegel (P1) bereitstellt, falls die beiden verglichenen Potentiale (U1, Ubat) im Freilauf ungleich sind;
b) einen zweiten Komparator (92), welcher so eingerichtet ist, daß er ein zweites Potential (U2), das an einer Verbindung zwischen der zweiten Schaltvorrichtung (32) und der Last (4) anliegt, mit dem Versorgungspotential (Ubat) vergleicht und ausgangsseitig einen positiven logischen Signalpegel (P2) bereitstellt, falls die beiden verglichenen Potentiale (U2, Ubat) im Freilauf ungleich sind;
c) einen dritten Komparator (93), welcher so eingerichtet ist, daß er ein drittes Potential (U3), das an einer Verbindung zwischen der dritten Schaltvorrichtung (33) und der Last (4) anliegt, mit dem Massepotential (U0) vergleicht und ausgangsseitig einen positiven logischen Signalpegel (P3) bereitstellt, falls die beiden verglichenen Potentiale (U3, U0) im Freilauf ungleich sind; und
d) einen vierten Komparator (94), welcher so eingerichtet ist, daß er ein viertes Potential (U4), das an einer Verbindung zwischen der vierten Schaltvorrichtung (34) und der Last (4) anliegt, mit dem Massepotential (U0) vergleicht und ausgangsseitig einen positiven logischen Signalpegel (P4) bereitstellt, falls die beiden verglichenen Potentiale (U4, U0) im Freilauf ungleich sind*.*

6. Schaltungsanordnung nach Anspruch 5,
**dadurch gekennzeichnet,**
**dass** die Auswerteeinrichtung (10) so eingerichtet ist, daß sie die von den Komparatoren (91-94) ausgangsseitig bereitgestellten Signalpegel (P1-P4) auswertet und dabei einen Leitungsbruch (1) feststellt, falls kein Komparator (91-94) im Freilauf einen positiven Signalpegel (P1-P4) liefert.

7. Schaltungsanordnung nach einem oder mehreren der vorstehenden Ansprüche,
**dadurch gekennzeichnet,**
**dass** zumindest eine Schaltvorrichtung (31 - 34) als MOSFET, insbesondere als Leistungs-MOSFET ausgebildet ist.

8. Schaltungsanordnung nach einem oder mehreren der vorstehenden Ansprüche,
**dadurch gekennzeichnet,**
**dass** zumindest eine Schaltvorrichtung (31 - 34) als Bipolartransistor mit Freilaufdiode ausgebildet ist.

9. Schaltungsanordnung nach einem oder mehreren der vorstehenden Ansprüche,
**dadurch gekennzeichnet,**
**dass** zumindest eine Schaltvorrichtung (31 - 34) als Darlington-Transistor mit Freilaufdiode ausgebildet ist.

10. Schaltungsanordnung nach einem oder mehreren der vorstehenden Ansprüche,
**dadurch gekennzeichnet,**
**dass** zumindest eine Schaltvorrichtung (31 - 34) als IGBT mit Freilaufdiode ausgebildet ist.

## Claims

1. Method for continuously detecting a wire break (1) in a full bridge (2) driving an inductive load (4), said full bridge containing four switching devices (31-34) operated between a supply potential (Ubat) and an earth potential (U0), said method comprising the following steps:
a) switching off or switching over the full bridge (2), with one predeterminable switching device (31-34) being switched first;
b) tapping off a potential (U1-U4) present at a connection between the switching device (31-34) switched first and the load (4);
**characterised by**:
c) comparing the tapped-off potential (U1-U4) with the supply potential (Ubat) if the switching device (33, 34) switched first is connected to the earth potential (U0), or with the earth potential (U0) if the switching device (31, 32) switched first is connected to the supply potential (6); and
d) detecting a wire break (1) if the two compared potentials (U1-U4, U0, Ubat) are not different in the freewheeling state.

2. Circuit arrangement for continuously detecting a wire break (1) in a full bridge (2) driving an inductive load (4), said full bridge containing four switching devices (31-34) operated between a supply potential (Ubat) and an earth potential (U0), comprising:
a) a control circuit (8) which is set up in such a way that it switches over or switches off the full bridge (2), said control circuit (8) switching one predeterminable switching device (31-34) first;
**characterised by**:
b) a comparison device (90) which is set up in such a way that it compares a potential (U1-U4) present at a connection between the switching device (31-34) switched over first and the load (4) with the supply potential (Ubat) if the switching device switched first (33, 34) is connected to the earth potential (U0), or with the earth potential (U0) if the switching device (31, 32) switched first is connected to the supply potential (Ubat), and provides a positive signal level (P1-P4) on the output side if the two compared potentials (U1-U4, U0, Ubat) are different in the freewheeling state; and
c) an evaluator (10) which is set up in such a way that it receives the signal level (P1-P4) provided on the input side, and determines a presence of the wire break (1) if the received signal level (P1-P4) is not positive in the freewheeling state.

3. Circuit arrangement according to claim 2,
**characterised in that** one diode (7) respectively is arranged parallel to a load junction of each of the switching devices (31-34).

4. Circuit arrangement according to claim 2,
**characterised in that** the control circuit (8) is set up in such a way that it generates a control signal (S1-S4) for the switching devices (31-34) with which the switching devices (31-34) may each be switched over, the control circuit (8) transmitting precisely one of four control signals (S1-S4) prior to other control signals (S1-S4) for switching over the predeterminable switching device (31-34).

5. Circuit arrangement according to claim 2,
**characterised in that** the comparison device (90) comprises:
a) a first comparator (91) which is set up in such a way that it compares a first potential (U1) present at a connection between the first switching device (31) and the load (4) with the supply potential (Ubat) and provides a positive logical signal level (P1) on the output side if the two compared potentials (U1, Ubat) are different in the freewheeling state;
b) a second comparator (92) which is set up in such a way that it compares a second potential (U2) present at a connection between the second switching device (32) and the load (4) with the supply potential (Ubat) and provides a positive logical signal level (P2) on the output side if the two compared potentials (U2, Ubat) are different in the freewheeling state;
c) a third comparator (93) which is set up in such a way that it compares a third potential (U3) present at a connection between the third switching device (33) and the load (4) with the earth potential (U0) and provides a positive logical signal level (P3) on the output side if the two compared potentials (U3, U0) are different in the freewheeling state; and
d) a fourth comparator (94) which is set up in such a way that it compares a fourth potential (U4) present at a connection between the fourth switching device (34) and the load (4) with the earth potential (U0) and provides a positive logical signal level (P4) on the output side if the two compared potentials (U4, U0) are different in the freewheeling state.

6. Circuit arrangement according to claim 5,
**characterised in that** the evaluator (10) is set up in such a way that it evaluates the signal levels (P1-P4) provided by the comparators (91-94) on the output side, and detects a wire break (1) if none of the comparators (91-94) delivers a positive signal level (P1-P4) in the freewheeling state.

7. Circuit arrangement according to one or more of the preceding claims,
**characterised in that** at least one switching device (31-34) is implemented as a MOSFET, in particular a power MOSFET.

8. Circuit arrangement according to one or more of the preceding claims,
**characterised in that** at least one switching device (31-34) is implemented as a bipolar transistor with a freewheeling diode.

9. Circuit arrangement according to one or more of the preceding claims,
**characterised in that** at least one switching device (31-34) is implemented as a Darlington transistor with a freewheeling diode.

10. Circuit arrangement according to one or more of the preceding claims,
**characterised in that** at least one switching device (31-34) is an IGBT with a freewheeling diode.

## Revendications

1. Procédé pour la détection continue d'une rupture de ligne (1) dans le cas d'un pont entier (2) activant une charge (4) inductive, qui contient quatre dispositifs de commutation (31-34) fonctionnant entre un potentiel d'alimentation (Ubat) et un potentiel de masse (U0), comprenant les étapes suivantes :
a) déconnexion ou commutation du pont entier (2), un dispositif de commutation (31-34), pouvant être prédéfini, est d'abord commuté ;
b) prélèvement d'un potentiel (U1-U4) s'appliquant sur une liaison entre le dispositif de commutation (31-34) commuté en premier et la charge (4) ;
**caractérisé par**
c) comparaison du potentiel (U1-U4) prélevé avec le potentiel d'alimentation (Ubat), au cas où le dispositif de commutation (33, 34) commuté en premier est relié au potentiel de masse (U0) ou le potentiel de masse (U0) dans le cas où le dispositif de commutation (31, 32) commuté en premier est relié au potentiel d'alimentation (6), et
d) constatation d'une rupture de ligne (1), lorsque les deux potentiels (U1-U4, U0, Ubat) comparés sont identiques en marche à vide.

2. Agencement de circuit pour la détection continue d'une rupture de ligne (1) dans le cas d'un pont entier (2) activant une charge (4) inductive, qui contient quatre dispositifs de commutation (31-34) fonctionnant entre un potentiel d'alimentation (Ubat) et un potentiel de masse (U0), comprenant :
a) un circuit de commande (8), qui est conçu de telle sorte qu'il commute ou déconnecte le pont entier (2), le circuit de commande (8) commutant d'abord un dispositif de commutation (31-34) prédéfinissable ;
**caractérisé par** :
b) un dispositif de comparaison (90), qui est conçu de telle sorte qu'il compare un potentiel (U1-U4) s'appliquant sur une liaison entre le dispositif de commutation (31-34) commuté en premier et la charge (4) avec le potentiel d'alimentation (Ubat), dans le cas où le dispositif de commutation (33, 34) commuté en premier est relié au potentiel de masse (U0), ou le potentiel de masse (U0) dans le cas où le dispositif de commutation (31, 32) commuté en premier est relié au potentiel d'alimentation (Ubat), et met à disposition côté sortie un niveau de signal (P1-P4) positif, lorsque les deux potentiels (U1-U4, U0, Ubat) comparés sont différents en marche libre, et
c) un dispositif d'analyse (10), qui est conçu de telle sorte qu'il reçoit côté entrée le niveau de signal (P1-P4) mis à disposition et constate qu'on a une rupture de ligne (1), lorsque le niveau de signal (P1-P4) reçu n'est pas positif en marche libre.

3. Agencement de circuit selon la revendication 2,
**caractérisé en ce que**
à chaque fois une diode (7) est disposée parallèlement à un tronçon de charge de chaque dispositif de commutation (31-34).

4. Agencement de circuit selon la revendication 2,
**caractérisé en ce que**
le circuit de commande (8) est conçu de telle sorte qu'il génère à chaque fois un signal de commande (S1-S4) pour les dispositifs de commutation (31-34), avec lesquels les dispositifs de commutation (31-34) peuvent être commutés à chaque fois, le circuit de commande (8) transmettant exactement l'un des quatre signaux de commande (S1-S4) avant les autres signaux de commande (S1-S4) pour la commutation sur un dispositif de commutation (31-34) prédéfinissable.

5. Agencement de circuit selon la revendication 2,
**caractérisé en ce que**
le dispositif de comparaison (90) présente :
a) un premier comparateur (91), qui est conçu de telle sorte qu'il compare un premier potentiel (U1), qui s'applique sur une liaison entre le premier dispositif de commutation (31) et la charge (4), avec le potentiel d'alimentation (Ubat) et met à disposition côté sortie un niveau de signal (P1) logique positif dans le cas où les deux potentiels (U1, Ubat) comparés sont différents en marche libre ;
b) un second comparateur (92), qui est conçu de telle sorte qu'il compare un second potentiel (U2), qui s'applique sur une liaison entre le second dispositif de commutation (32) et la charge (4), avec le potentiel d'alimentation (Ubat) et met à disposition côté sortie un niveau de signal (P2) logique positif dans le cas où les deux potentiels (U1, Ubat) comparés sont différents en marche libre ;
c) un troisième comparateur (93), qui est conçu de telle sorte qu'il compare un troisième potentiel (U3), qui s'applique sur une liaison entre le troisième dispositif de commutation (33) et la charge (4), avec le potentiel de masse (U0) et met à disposition côté sortie un niveau de signal (P3) logique positif dans le cas où les deux potentiels (U3, U0) comparés sont différents en marche libre ;
d) un quatrième comparateur (94), qui est conçu de telle sorte qu'il compare un quatrième potentiel (U4), qui s'applique sur une liaison entre le quatrième dispositif de commutation (34) et la charge (4), avec le potentiel de masse (U0) et met à disposition côté sortie un niveau de signal (P4) logique positif dans le cas où les deux potentiels (U4, U0) comparés sont différents en marche à vide.

6. Agencement de circuit selon la revendication 5,
**caractérisé en ce que**
le dispositif d'analyse (10), qui est conçu de telle sorte qu'il analyse les niveaux de signal (P1-P4) mis à disposition côté sortie par les comparateurs (91-94) et constate alors une rupture de ligne (1) dans le cas où aucun comparateur (91-94) ne fournit un niveau de signal positif (P1-P4) en marche à vide.

7. Agencement de circuit selon l'une quelconque ou plusieurs des revendications précédentes,
**caractérisé en ce que**
au moins un dispositif de commutation (31-34) est conçu sous forme de MOSFET, en particulier sous forme de MOSFET de puissance.

8. Agencement de circuit selon l'une quelconque ou plusieurs des revendications précédentes,
**caractérisé en ce que**
au moins un dispositif de commutation (31-34) est conçu sous forme de transistor bipolaire avec diode de marche à vide.

9. Agencement de circuit selon l'une quelconque ou plusieurs des revendications précédentes,
**caractérisé en ce que**
au moins un dispositif de commutation (31-34) est conçu sous forme de transistor Darlington avec diode de marche à vide.

10. Agencement de circuit selon l'une quelconque ou plusieurs des revendications précédentes,
**caractérisé en ce que**
au moins un dispositif de commutation (31-34) est conçu sous forme de IGBT avec diode de marche à vide.
